(19) Europäisches Patentamt
European Patent Office
Office européen des brevets

(11) **EP 4 202 551 A1**

(12) **EUROPEAN PATENT APPLICATION**

(43) Date of publication:
**28.06.2023 Bulletin 2023/26**

(51) International Patent Classification (IPC):
***G03F 7/20*** (2006.01)    ***H01L 21/66*** (2006.01)

(21) Application number: **21217598.8**

(52) Cooperative Patent Classification (CPC):
**G03F 7/70633; G03F 7/70491; G03F 7/70783;**
**H01L 22/12**

(22) Date of filing: **23.12.2021**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **ZHANG, Huaichen**
 **5500 AH Veldhoven (NL)**

• **TIMOSHKOV, Vadim Yourievich**
 **5500 AH Veldhoven (NL)**
• **TABERY, Cyrus, Emil**
 **San Jose, 95134 (US)**
• **HAUPTMANN, Marc**
 **5500 AH Veldhoven (NL)**
• **KHODKO, Oleksandr**
 **5500 AH Veldhoven (NL)**

(74) Representative: **ASML Netherlands B.V.**
**Corporate Intellectual Property**
**P.O. Box 324**
**5500 AH Veldhoven (NL)**

(54) **METHODS OF DETERMINING A MECHANICAL PROPERTY OF A LAYER APPLIED TO A SUBSTRATE, AND ASSOCIATED DEVICES**

(57)    Disclosed is a method for determining a mechanical property of a layer applied to a substrate. The method comprises obtaining input data comprising metrology data relating to said layer and layout data relating to a layout of a pattern to be applied in said layer. A first model or first model term is used to determine a global mechanical property related to said layer based on at least said input data; and at least one second model or at least one second model term is used to predict a mechanical property distribution or associated overlay map based on said first mechanical property and said layout data, the mechanical property distribution describing the mechanical property variation over said layer.

Fig. 4

**Description**

FIELD OF INVENTION

The present invention relates to control apparatus and control methods usable, for example, to maintain performance in the manufacture of devices by patterning processes such as lithography. The invention further relates to methods of manufacturing devices using lithographic techniques. The invention yet further relates to computer program products for use in implementing such methods.

RELATED ART

A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself.

Stress and in-plane distortions of the substrate can, in some cases, be determined via measurements of the shape (e.g., slope) of a clamped or unclamped substrate. Such in-plane distortions may result from one or more stress inducing layers being applied to the substrate.

SUMMARY OF THE INVENTION

The present invention aims to improve systems for control of performance in parameters such as overlay in lithographic processes.

More specifically, the present invention aims to improve measurement of a mechanical property such as stress or in-plane distortion of a substrate.

According to a first aspect of the present invention there is provided a method for determining a mechanical property of a layer applied to a substrate, the method comprising:

> obtaining input data comprising metrology data relating to said layer; obtaining layout data relating to a layout of a pattern to be applied in said layer; using a first model or first model term to determine a global mechanical property related to said layer based on at least said input data; and using at least one second model or at least one second model term to predict a mechanical property distribution or
> associated overlay map based on said first mechanical property and said layout data, the mechanical property distribution describing the mechanical property variation over said layer.

According to a second aspect of the present invention there is provided a computer program product containing one or more sequences of machine-readable instructions for implementing calculating steps in a method according to the first aspect of the invention as set forth above

The invention yet further provides a processing arrangement, metrology device and lithographic apparatus comprising the computer program of the second aspect.

These and other aspects and advantages of the apparatus and methods disclosed herein will be appreciated from a consideration of the following description and drawings of exemplary embodiments.

BRIEF DESCRIPTION OF THE DRAWINGS

Embodiments of the invention will now be described, by way of example only, with reference to the accompanying schematic drawings in which corresponding reference symbols indicate corresponding parts, and in which:

> Figure 1 depicts a lithographic apparatus suitable for use in an embodiment of the present invention;
> Figure 2 depicts a lithographic cell or cluster in which an inspection apparatus according to the present invention may be used;

Figure 3 illustrates schematically measurement and exposure processes in the apparatus of Figure 1, according to known practice;

Figure 4 is a flowchart describing a method according to an embodiment.

DETAILED DESCRIPTION OF EXEMPLARY EMBODIMENTS

Before describing embodiments of the invention in detail, it is instructive to present an example environment in which embodiments of the present invention may be implemented.

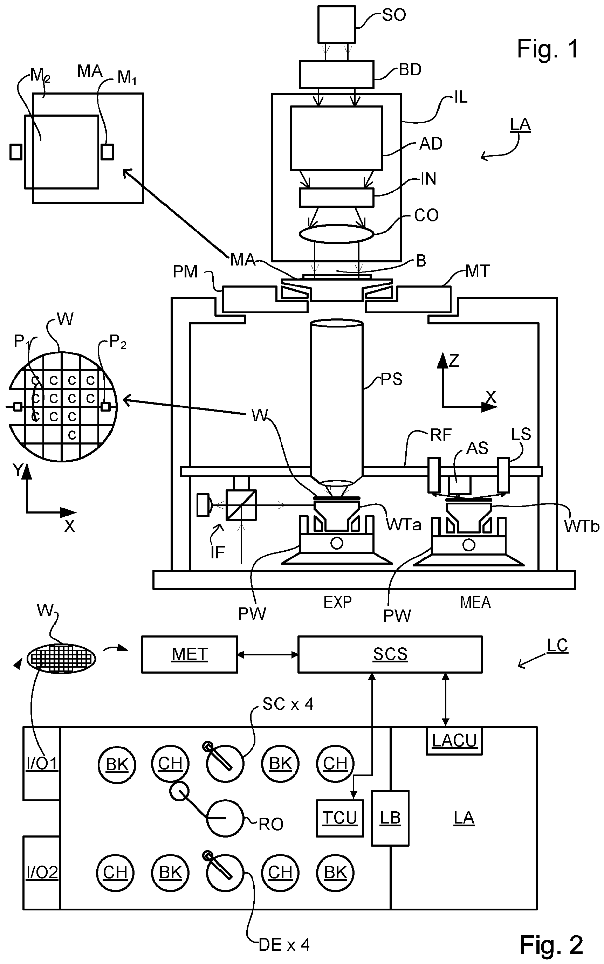

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation. For example, in an apparatus using extreme ultraviolet (EUV) radiation, reflective optical components will normally be used.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers, is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. On a single stage apparatus, the preparatory steps and exposure steps need to be performed sequentially on the single stage, for each substrate. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it may be desirable that the inspection apparatus measure properties in the exposed resist layer immediately after the exposure. However, not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

The metrology step with metrology system MET can also be done after the resist pattern has been etched into a product layer. The latter possibility limits the possibilities for rework of faulty substrates but may provide additional information about the performance of the manufacturing process as a whole.

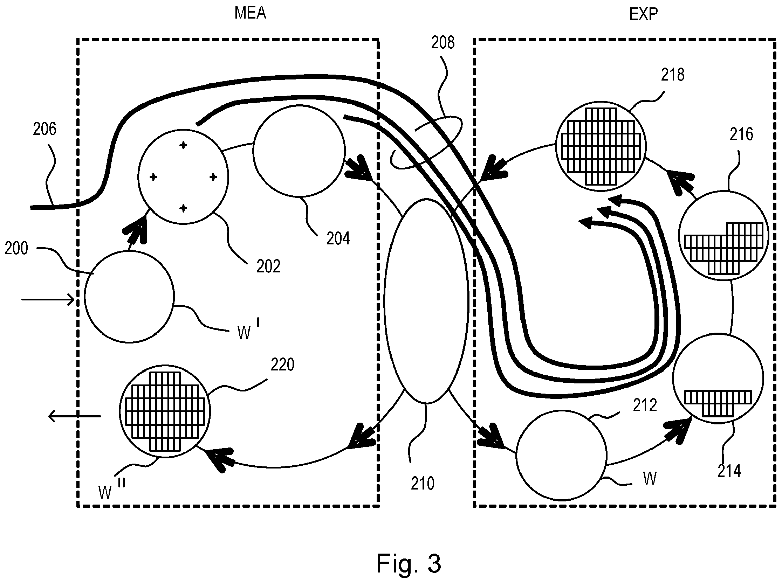

Figure 3 illustrates the steps to expose target portions (e.g. dies) on a substrate W in the dual stage apparatus of Figure 1. The process according to conventional practice will be described first. The present disclosure is by no means limited to dual stage apparatus of the illustrated type. The skilled person will recognize that similar operations are performed in other types of lithographic apparatus, for example those having a single substrate stage and a docking metrology stage.

On the left hand side within a dotted box are steps performed at measurement station MEA, while the right hand side shows steps performed at exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. Each patterning step can introduce positional deviations in the applied pattern, while subsequent processing steps progressively introduce distortions in the substrate and/or the pattern applied to it that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation. Some layers may be patterned by steps that are alternative or supplementary to exposure in the illustrated lithographic apparatus. Such alternative and supplementary techniques include for example imprint lithography, self-aligned multiple patterning and directed self-assembly. Similarly, other processing steps performed per layer (e.g., CMP and etch) may be performed on different apparatuses per layer.

At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a substrate model (sometimes referred to as the "wafer grid"), which maps very accurately the distribution of marks across the substrate, including any distortion relative to a nominal rectangular grid.

At step 204, a map of wafer height (Z) against X-Y position is measured also using the level sensor LS. Primarily, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. Where there is a choice of alignment marks on the substrate, and where there is a choice of settings of an alignment sensor, these choices are defined in an alignment recipe among the recipe data 206. The alignment recipe therefore defines how positions of alignment marks are to be measured, as well as which marks.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

Substrate distortion may impact overlay performance in a lithographic process. Substrate distortion may result from a thermal treatment of the substrate (e.g. laser anneal) or deposition of stressed thin films. The free-form substrate shape, which can be measured with off-line metrology tools, may change as a result of this distortion. Typical shapes which may be observed in high volume manufacturing are bowl (convex), umbrella (concave), and saddle shapes. Deviations from these shapes result in higher order in-plane distortions. In some cases, these in-plane distortions are slowly spatially varying functions that can be captured by existing alignment models, such as (for example) high order wafer alignment (HOWA) models. An important precondition is that the grid distortions remain global as the polynomial-based HOWA models become less effective for very local distortions.

Another approach is to use substrate shape or deformation measurements. Such substrate shape measurements may comprise out-of-plane deformation measurements; i.e., measurements of the shape of the substrate in the z-direction, normal to the substrate surface plane. The substrate shape measurements may comprise measurements of the free-form (unclamped) substrate shape, or may be obtained from measurement of a clamped substrate. Any reference to the substrate shape encompasses any suitable measurement of the out-of-plane deformation of the substrate by any of these, or other, methodologies. Where the relationship between free-form substrate shape and in-plane distortion (IPD) after clamping is known or can be modelled, predictions (and corrections) can be made to improve overlay performance.

Such a local wafer shape measurement can only be used to retrieve a low-resolution stress map, e.g., at the millimeter scale, and is therefore not sufficient to cover high spatial frequency stress-induced overlay fingerprints. Furthermore, the wafer shape metrology itself can be sensitive to front side topography, which may lead to signals falsely interpreted as real local wafer shape. The predictive accuracy also strongly depends on the model used to translate the measured shape into overlay, which also depends on a number of aspects such as utilization of backside coatings.

One contributor to in-plane distortion may be the application of a stressor to the substrate; for example an applied layer or thin film deposition. Thin film stress typically has an impact on the unclamped, free-form shape of the substrate. This stressor results in a change or distortion of the substrate shape. Stressed thin films may produce a local overlay error after etching; such an overlay error often has high spatial frequency and may vary per wafer and across the wafer.

Presently, high resolution overlay control may be effected (in addition to the aforementioned alignment techniques) via post-exposure metrology such as overlay metrology. The majority of overlay metrology is performed on targets within scribe-lanes and/or on targets having dimensions significantly larger than the product features; e.g., using diffraction based overlay (DBO) techniques which measure an imbalance in complementary higher order diffraction orders (e.g., the +1 and -1 diffraction orders) having diffracted from the target. DBO metrology has the advantage of being relatively fast compared to many other overlay metrology techniques. However, such metrology tends to result in a mark-to-device (MTD) offset, where the overlay target behaves differently to the product structure and therefore overlay measured on the target is not truly representative of overlay of the product structure (the overlay of interest or parameter of interest).

Other methods of measuring overlay which address the MTD issue include in-device metrology (IDM) or scanning electron microscope (SEM) metrology. However both approaches are significantly slower than DBO and as such, their application is limited by throughput requirements. Furthermore, IDM may require the product features to be periodic or to be performed on dedicated targets within the product area, which is not always possible. Because of this, if IDM or SEM metrology is performed at all, it is typically only performed on a small fraction of all wafers, resulting in a limited control of wafer-to-wafer variation of process induced overlay variation (in particular at small spatial scale such as at an intra-field / die level scale).

As such, disclosed herein is a method for determining a mechanical property such as an in-plane deformation or stress distribution (e.g., a stress map describing an effective thin film property over a substrate area or part thereof resultant from application of a stressor such as a film) and/or a derived overlay map for use in monitoring and/or process control in a lithographic process.

The proposed method may use alignment data and/or other metrology data to infer global or average wafer stress associated with certain layer(s) using a first model, which may predict stress corresponding to the alignment or metrology data fingerprint. Once global stress is deduced, a second model may use device layout information (e.g., *inter alia* field layout and/or pattern density) to predict a die level (dense) stress distribution. This can be used to deduce impact on IPD and determine a dense intra-die overlay fingerprint.

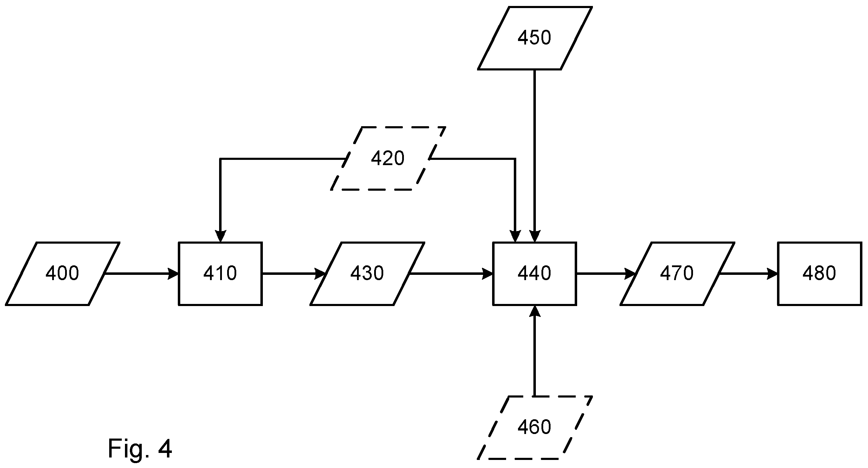

Figure 4 is a flow diagram describing such a method. Input data such as alignment data 400 (e.g., coarse and fine alignment data) is obtained, e.g., as measured using an alignment sensor. An advantage of alignment data is that it is already presently measured for each wafer. However the concepts disclosed herein are not limited to using alignment data, nor only alignment data. Alternatively or in addition, other metrology data may be used as the input data in this step. Such metrology data may comprise any metrology data which is a measure of or is indicative of one or more of: overlay, film thickness and stress levels. Such input data may comprise one or more of: wafer shape data, any overlay data (e.g. SEM overlay data or optical overlay data), ellipsometry metrology of film properties, Raman spectroscopy data, profile metrology, focus data (which can be used to infer wafer shape, mainly at edge of wafer).

The input data (e.g., alignment data or alignment position deviation (APD) data) may be inputted into a first model or wafer scale model 410. The first model 410 may use the alignment data to reverse fit or model the effective thin film properties or global stress 430 of the previous patterned layer. As a specific example, the stress distribution or effective thin film property $\sigma_{eff}$ may be related to the product of the thin film tension $\sigma$ and film thicknesses $h$ summed over the lithography layers $i$; e.g.,:

$$\sigma_{eff} = \left.\sum_i \sigma_i h_i \middle/ \sum_i h_i\right.$$

Additional information 420 may be used to improve accuracy of the stress prediction 430. This additional information 420 may comprise one or more of: stack and approximate stress properties (e.g., including properties of any backside coating, where a backside coating may be applied to compensate for shape changes caused by the frontside coating(s)) and any metrology (e.g., alignment data) relating to one or more previous lithography layers. By way of a specific example, when a backside coating is applied, the global warp of the substrate will change but local distortion will remain; the additional information may therefore be used to decorrect, when a backside compensation is applied, for any warp terms that were added to model the warp resultant from the (frontside) film or stressor application.

The wafer scale first model 410 may comprise, but is not limited to, a model of thin film stress-induced wafer deformation; temperature induced deformation; wafer bonding induced substrate and superstrate deformation. In an embodiment, the wafer scale model can be a calibrated static library, e.g., for table lookup and/or interpolation.

The global stress or effective thin film properties 430 may be exported from the wafer-level model into a second model or die-level stress model module 440. Layout or floorplan information 450 may be used to determine a fine-grid on-product (e.g., after etch) stress distribution (map) or overlay distribution (map) 470. Alternatively, the die-level model 440 can be pre-calculated as a static library of stress or overlay distributions according to certain fixed layout/floorplan options and patched into the model 440.

The layout or floorplan information 450 may comprise for example, one or more of: the number and/or position and/or dimensions of dies within a field, the layout file (e.g., .gds file) and pattern density (the latter may be determined from the layout file). Pattern density is correlated with stress (the patterned material, which is removed in etch, carries stress).

Optionally, other indicators 460 may be used by the model 440 in determining the stress distribution or overlay distribution 470. Such indicators may comprise one or more of: a wafer alignment readout wafer quality indicator, an overlay stack sensitivity indicator, and level sensor data. These indicators may be used, for example, to better infer the thin film thickness distribution across different wafer locations, for more accurate prediction of the on-product stress/overlay fingerprints. Additionally, or alternatively the second model may also use the aforementioned additional information 420 in determining the mechanical property (stress distribution).

At step 480, the stress distribution or overlay distribution can be used for monitoring (e.g., send ahead and metrology generation) and/or feed-forward control of the lithographic process (exposure process).

It may be appreciated that the first model and second model may comprise different terms of a single model. For example, the first model may be the zeroth order or field magnification term (in terms of $r$ where $r = \sqrt{x^2 + y^2}$

and $x$ and $y$ are Cartesian coordinates in the substrate plane).

The second model may comprise one or more higher order terms, e.g., at least a first order bulk response term (e.g., in terms of $r^1$). Such a first order term may describe the thin film addition attached to substrate with no $z$-dependency (2D substrate plane). The second model may also comprise an additional second order local response term or 3D term (e.g., in terms of $r^2$).

A specific first model and second model will now be described. Such models are only exemplary and may vary from the detailed model shown.

The first model or first term (field magnification term) may take the form:

$$\varepsilon_s = \frac{(1 - v_s)\bar{\sigma}_f h_f}{E_s h_s}$$

where $v$ is the Poisson Ratio, $\bar{\sigma}$ is the mean stress, $E$ is elastic modulus, $h$ is thickness and $\varepsilon$ is strain and the subscripts $s$ and $f$ relate to the substrate and film respectively.

A first order (2D) bulk response term of the second model may comprise:

$$u_x(x,y) = \frac{\left(1 + v_f\right)(1 - v_s)h_f}{2\pi E_s h_s} \sigma_f(x,y) \otimes \frac{x}{x^2 + y^2}$$

where $u$ is displacement / distortion, $\sigma_f(x, y)$ is the stress distribution and $\otimes$ is the convolution operator

A second order local response term of the second model which introduces the $z$ dimension (i.e., the direction normal to the substrate plane defined by $x$ and $y$) may comprise:

$$u_x(x,y) = \frac{(1 + v_s)(3 - 4v_s)h_f}{4\pi E_s(1 - v_s)} \sigma(x,y) \otimes \frac{x}{(r^2 + z^2)^{3/2}}$$

note that in this description, $\sigma(x, y)$ as the 3D approximation no longer distinguishes film stress and substrate stress (it may be represented as film stress $\sigma_f(x, y)$, as before).

The above models may be used to model the stress distribution isotopically. However, improved performance will be obtained if the stress distribution is modeled anisotropically.

It may be appreciated that the above terms may be represented in a simplified form, e.g., the first order term may be represented as:

$$u_x(x,y) = C * \sigma_f(x,y) \otimes f(x,y)$$

and the second order term may be represented as:

$$u_x(x,y) = D * \sigma(x,y) \otimes f(x,y,z)$$

where $f(x, y)$, $f(x, y, z)$ are geometric functions of Cartesian coordinates (e.g., as have been described, but may take other forms), and derived parameters $C$ and $D$ each comprise a constant or which links film thickness, Poisson ratio and substrate thickness. In such an embodiment, these parameters $C$ and $D$ may each be treated as single parameters which can be calibrated in this form.

A more detailed exemplary method for anisotropically modeling of the stress distribution based on alignment data (APD data) and layout data (pattern density data) will now be described.

The method may comprise fitting the measured APD values $apd_x$ $(x, y)$, $apd_y$ $(x, y)$ (assuming alignment data as input data) to the first model (wafer scale model):

$$apd_x(x,y) = \varepsilon_x * x$$

$$apd_y(x,y) = \varepsilon_y * y$$

where anisotropic strain $\varepsilon_x$, $\varepsilon_y$ is given by the anisotropic first model (anisotropic magnification term):

$$\varepsilon_x = \varepsilon_{iso} + \bar{\sigma}_{aniso}\frac{(1+v_s)\,h_f}{E_s h_s}$$

$$\varepsilon_y = \varepsilon_{iso} - \bar{\sigma}_{aniso}\frac{(1+v_s)\,h_f}{E_s h_s}$$

and $\varepsilon_{iso}$ is the isotropic strain (isotropic first model as already described):

$$\varepsilon_{iso} = \frac{(1-v_s)\,h_f}{E_s h_s}\bar{\sigma}$$

$\bar{\sigma}$ is the mean isotropic stress and $\bar{\sigma}_{aniso}$ is the mean anisotropic stress.

As $E_s$, $h_s$ and $v_s$ are known substrate (crystalline silicon) constants, the strain values $\varepsilon_x$, $\varepsilon_y$ can be put into the model to determine the isotopic thin film property (mean stress and film thickness product term) $\overline{\sigma}h_f$ and anisotropic thin film property $\overline{\sigma}_{aniso}h_f$.

In fitting the second model, the method may comprise precomputing the isotropic and anisotropic stress distributions $\sigma(x, y)$, $\sigma_{aniso}(x, y)$:

$$\sigma(x,y) = \sigma_0 * \rho(x,y) * C1(x,y)$$

$$\sigma_{aniso}(x,y) = \sigma_0 * \rho(x,y) * C2(x,y)$$

where $\rho(x, y)$ is the pattern density distribution, where pattern density may be the ratio of the patterned area to the total area and C1 and C2 are (optional) correction factors. These correction factors may be dependent on other design parameters such as pitch density or perimeter density; C1 may be a dimensionless number between zero and 1 (e.g., approximately 1) and C2 a dimensionless number between -1 and 1 (e.g., approximately zero). $\sigma_0$ is the initial stress of the blanket film before etching.

The mean stress determined using the first model may be converted to the stress distribution using:

$$\mathrm{mean}[\sigma(x,y)] = \bar{\sigma}$$

$$\mathrm{mean}[\sigma_{aniso}(x,y)] = \bar{\sigma}_{aniso}$$

this enables calibration of the prefactors, i.e., $h_f$, C1, C2

Following this, $\sigma(x, y)h_f$ and $\sigma_{aniso}(x, y)h_f$ can be plugged into the second order models (recited below) to obtain a dense distortion map prediction:

First order isotropic bulk response:

$$u_{x,iso}(x,y) = \frac{(1+v_f)(1-v_s)h_f}{2\pi E_s h_s}\sigma(x,y) \otimes \frac{x}{r^2}$$

$$u_{y,iso}(x,y) = \frac{(1+v_f)(1-v_s)h_f}{2\pi E_s h_s}\sigma(x,y) \otimes \frac{y}{r^2}$$

First order anisotropic bulk response:

$$u_x(x,y) = u_{x,iso} + \frac{(1+v_f)(1-v_s)h_f}{2\pi E_s h_s}\sigma_{aniso}(x,y) \otimes \frac{x}{r^2}\left(\frac{1-v_f}{1+v_f} + \frac{x^2-y^2}{r^2}\right)$$

$$u_y(x,y) = u_{y,iso} - \frac{(1+v_f)(1-v_s)h_f}{2\pi E_s h_s}\sigma_{aniso}(x,y) \otimes \frac{y}{r^2}\left(\frac{1-v_f}{1+v_f} + \frac{y^2-x^2}{r^2}\right)$$

Second order front side isotropic local response:

$$u_{x,iso}(x,y) = \frac{(1+v_s)(3-4v_s)h_f}{4\pi E_s(1-v_s)}\sigma(x,y) \otimes \frac{x}{(r^2+z^2)^{3/2}}\left(1 - \frac{3}{3-4v_s}\frac{z^2}{r^2+z^2}\right)$$

$$u_{y,iso}(x,y) = \frac{(1+v_s)(3-4v_s)h_f}{4\pi E_s(1-v_s)}\sigma(x,y) \otimes \frac{y}{(r^2+z^2)^{3/2}}\left(1 - \frac{3}{3-4v_s}\frac{z^2}{r^2+z^2}\right)$$

Second order front side anisotropic local response

$$u_x(x,y) = u_{x,iso} + \frac{(1+v_s)(3-4v_s)h_f}{4\pi E_s(1-v_s)}\sigma_{aniso}(x,y) \otimes \frac{x}{(r^2+z^2)^{3/2}}\left(\frac{2-4v_s}{3-4v_s} + \frac{3}{3-4v_s}\frac{x^2-y^2}{r^2+z^2}\right)$$

$$u_y(x,y) = u_{y,iso} - \frac{(1+v_s)(3-4v_s)h_f}{4\pi E_s(1-v_s)}\sigma_{aniso}(x,y) \otimes \frac{y}{(r^2+z^2)^{3/2}}\left(\frac{2-4v_s}{3-4v_s} + \frac{3}{3-4v_s}\frac{y^2-x^2}{r^2+z^2}\right)$$

Optionally, higher-order fingerprint maps ($fp1(x, y) ... fpn(x, y)$) may also be used. These higher-order fingerprint maps can be precomputed and stored in a library. During model fitting, a multilinear regress may be employed to fit e.g.: $apd(x, y) = c1 * fp1(x, y) + c2 * fp2(x, y) + c3 * fp3(x,y) ... cn * fpn(x, y)$. In this way, film thickness variations and etch condition variations across the wafer can also be inferred.

Further embodiments of the invention are disclosed in the list of numbered clauses below:

1. A method for determining a mechanical property of a layer applied to a substrate, the method comprising:

   obtaining input data comprising metrology data relating to said layer;
   obtaining layout data relating to a layout of a pattern to be applied in said layer;
   using a first model or first model term to determine a global mechanical property related to said layer based on at least said input data; and
   using at least one second model or at least one second model term to predict a mechanical property distribution or associated overlay map based on said first mechanical property and said layout data, the mechanical property distribution describing the mechanical property variation over said layer.

2. A method according to clause 1, wherein the mechanical property is related to stress within said layer.

3. A method according to clause 2, wherein said mechanical property is the product of stress and layer thickness or a derived parameter.

4. A method according to any preceding clause, wherein the first model or first model term determines a mean value for said mechanical property over said substrate.

5. A method according to any preceding clause, wherein said first model or first model term and at least one second model or second model term each comprise an isotropic model or model term.

5. A method according to any of clauses 1 to 4, wherein said first model or first model term and at least one second model or second model term each comprise an anisotropic model or model term.

6. A method according to any preceding clause, wherein said first model or first model term comprises a zeroth order magnification model term.

7. A method according to any preceding clause, wherein said step of using the first model or first model term comprises fitting the input data to the first model or first model term, to determine said first mechanical property.

8. A method according to any of clauses 1 to 6, wherein said first model or first model term comprises a calibrated static library of predetermined global mechanical properties, and said step of using the first model or first model term comprises selecting the appropriate predetermined mechanical property from said library based on said input data.

9. A method according to any preceding clause, wherein said first model or first model term models more than one of thin film stress-induced wafer deformation; temperature induced deformation; wafer bonding induced substrate and superstrate deformation.

10. A method according to any preceding clause, wherein said at least one second model or second model term comprises at least a first order bulk response model term.

11. A method according to clause 10, wherein said at least one second model or second model term comprises a second order local response model term.

12. A method according to any preceding clause, wherein said at least one second model or second model term additionally uses one or more of: a wafer alignment readout wafer quality indicator, an overlay stack sensitivity indicator, and level sensor data to determine said second mechanical property distribution or associated overlay map.

13. A method according to any preceding clause, wherein said layout data comprises one or more of: the number of dies within a field, the positions of dies within a field, the dimensions of dies within a field, the layout file and pattern density.

14. A method according to any preceding clause, wherein said input data comprises one or more of: alignment data, wafer shape data, overlay data, ellipsometry metrology of film properties, Raman spectroscopy data, profile metrology and focus data.

15. A method according to any preceding clause, wherein said at least one second model or second model term comprises a static library of predetermined stress or overlay distributions according to a plurality of different layout options; and said step of using the at least one second model or second model term comprises selecting the appropriate stress or overlay distribution from said library based on said layout data.

16. A method according to any of clauses 1 to 14, wherein said step of using the at least one second model or second model term comprises fitting the input data to said model over at least two coordinates associated with a substrate plane.

17. A method according to any preceding clause, wherein said layer is an applied stressor layer which stresses and deforms the substrate.

18. A method according to any preceding clause, comprising:

using said mechanical property distribution or associated overlay map to determine corrections for one or more subsequent production steps on said substrate.

19. A computer program comprising program instructions operable to perform the method of any preceding clause, when run on a suitable apparatus.

20. A non-transient computer program carrier comprising the computer program of clause 19.

21. A processing arrangement comprising:

a computer program carrier comprising the computer program of clause 19; and
a processor operable to run said computer program.

22. A metrology device comprising the processing arrangement of clause 21.

23. A lithographic apparatus comprising the processing arrangement of clause 21.

In association with the hardware of the lithographic apparatus and the lithocell LC, an embodiment may include a computer program containing one or more sequences of machine-readable instructions for causing the processors of the lithographic manufacturing system to implement methods of model mapping and control as described above. This computer program may be executed for example in a separate computer system employed for the image calculation/control process. Alternatively, the calculation steps may be wholly or partly performed within a processor a metrology tool, and/or the control unit LACU and/or supervisory control system SCS of Figures 1 and 2. There may also be provided a data storage medium (e.g., semiconductor memory, magnetic or optical disk) having such a computer program stored therein in non-transient form.

Although specific reference may have been made above to the use of embodiments of the invention in the context of optical lithography, it will be appreciated that the invention may be used in other patterning applications, for example imprint lithography. In imprint lithography, topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A method for determining a mechanical property of a layer applied to a substrate, the method comprising:

   obtaining input data comprising metrology data relating to said layer;
   obtaining layout data relating to a layout of a pattern to be applied in said layer;
   using a first model or first model term to determine a global mechanical property related to said layer based on at least said input data; and
   using at least one second model or at least one second model term to predict a mechanical property distribution or associated overlay map based on said first mechanical property and said layout data, the mechanical property distribution describing the mechanical property variation over said layer.

2. A method as claimed in claim 1, wherein the mechanical property is related to stress within said layer.

3. A method as claimed in claim 2, wherein said mechanical property is the product of stress and layer thickness.

4. A method as claimed in any preceding claim, wherein the first model or first model term determines a mean value for said mechanical property over said substrate.

5. A method as claimed in any preceding claim, wherein said first model or first model term and at least one second model or second model term each comprise an isotropic model or model term.

6. A method as claimed in any preceding claim, wherein said first model or first model term comprises a zeroth order magnification model term.

7. A method as claimed in any preceding claim, wherein said step of using the first model or first model term comprises fitting the input data to the first model or first model term, to determine said first mechanical property.

8. A method as claimed in any of claims 1 to 6, wherein said first model or first model term comprises a calibrated static library of predetermined global mechanical properties, and said step of using the first model or first model term comprises selecting the appropriate predetermined mechanical property from said library based on said input data.

9. A method as claimed in any preceding claim, wherein said first model or first model term models more than one of: thin film stress-induced wafer deformation; temperature induced deformation; wafer bonding induced substrate and superstrate deformation.

10. A method as claimed in any preceding claim, wherein said at least one second model or second model term comprises at least a first order bulk response model term.

11. A method as claimed in claim 10, wherein said at least one second model or second model term comprises a second order local response model term.

12. A method as claimed in any preceding claim, wherein said at least one second model or second model term additionally uses one or more of: a wafer alignment readout wafer quality indicator, an overlay stack sensitivity indicator, and level sensor data to determine said second mechanical property distribution or associated overlay map.

13. A method as claimed in any preceding claim, wherein said layout data comprises one or more of: the number of dies within a field, the positions of dies within a field, the dimensions of dies within a field, the layout file and pattern density.

14. A method as claimed in any preceding claim, wherein said input data comprises one or more of: alignment data, wafer shape data, overlay data, ellipsometry metrology of film properties, Raman spectroscopy data, profile metrology and focus data.

15. A method as claimed in any preceding claim, wherein said at least one second model or second model term comprises a static library of predetermined stress or overlay distributions according to a plurality of different layout options; and said step of using the at least one second model or second model term comprises selecting the appropriate stress or overlay distribution from said library based on said layout data.

Fig. 1

Fig. 2

Fig. 3

Fig. 4

EP 4 202 551 A1

EP 4 202 551 A1

Europäisches
Patentamt
European
Patent Office
Office européen
des brevets

# EUROPEAN SEARCH REPORT

Application Number

EP 21 21 7598

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | VAN HAREN RICHARD ET AL: "Intra-field stress impact on global wafer deformation", SPIE PROCEEDINGS; [PROCEEDINGS OF SPIE ISSN 0277-786X], SPIE, US, vol. 10959, 26 March 2019 (2019-03-26), pages 109591I-109591I, XP060119199, DOI: 10.1117/12.2515391 ISBN: 978-1-5106-3673-6 | 1-7, 12-14 | INV. G03F7/20 H01L21/66 |
| Y | * abstract * * pages 8-11 * | 1-8, 12-15 | |
| A | * pages 4-6 * | 9-11 | |
| | ----- | | |
| Y | US 2018/342410 A1 (HOOGE JOSHUA [US] ET AL) 29 November 2018 (2018-11-29) | 1-8, 12-15 | |
| A | * paragraphs [0017] - [0025], [0037] - [0041], [0043] - [0047], [0058] - [0062], [0073] - [0081], [0088] - [0096]; claims 1,4-6; figures 1,3,4,5 * | 9-11 | |
| | ----- | | |

TECHNICAL FIELDS
SEARCHED (IPC)

G03F
H01L

The present search report has been drawn up for all claims

| Place of search | Date of completion of the search | Examiner |
|---|---|---|
| Munich | 17 June 2022 | Roesch, Guillaume |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

17

## ANNEX TO THE EUROPEAN SEARCH REPORT
## ON EUROPEAN PATENT APPLICATION NO.

**EP 21 21 7598**

This annex lists the patent family members relating to the patent documents cited in the above-mentioned European search report.
The members are as contained in the European Patent Office EDP file on
The European Patent Office is in no way liable for these particulars which are merely given for the purpose of information.

**17-06-2022**

| Patent document cited in search report | | Publication date | Patent family member(s) | | Publication date |
|---|---|---|---|---|---|
| US 2018342410 | A1 | 29-11-2018 | CN | 107799451 A | 13-03-2018 |
| | | | JP | 2018041080 A | 15-03-2018 |
| | | | JP | 2022000917 A | 04-01-2022 |
| | | | KR | 20180027382 A | 14-03-2018 |
| | | | TW | 201826036 A | 16-07-2018 |
| | | | TW | 202025235 A | 01-07-2020 |
| | | | US | 2018067403 A1 | 08-03-2018 |
| | | | US | 2018068859 A1 | 08-03-2018 |
| | | | US | 2018068860 A1 | 08-03-2018 |
| | | | US | 2018068861 A1 | 08-03-2018 |
| | | | US | 2018342410 A1 | 29-11-2018 |
| | | | US | 2020058509 A1 | 20-02-2020 |

EPO FORM P0459

For more details about this annex : see Official Journal of the European Patent Office, No. 12/82